# FASCICULE DE BREVET EUROPEEN

(11) **EP 3 381 056 B1**
(45) Date de publication et mention de la délivrance du brevet: **09.09.2020**
(21) Numéro de dépôt: 16801467.8
(22) Date de dépôt: 25.11.2016
(51) Int. Cl.: H01L 27/146, H01L 31/103, H01L 31/18

(54) **DISPOSITIF DE PHOTO-DÉTECTION À RÉSEAU INTER-DIODES SUR-DOPÉ PAR DIFFUSION DE METAL ET PROCÉDÉ DE FABRICATION**
FOTODETEKTOR MIT INTERDIODENANORDNUNG UND ÜBERDOTIERT DURCH METALLDIFFUSION UND HERSTELLUNGSVERFAHREN
PHOTODETECTION DEVICE WHICH HAS AN INTER-DIODE ARRAY AND IS OVERDOPED BY METAL DIFFUSION AND MANUFACTURING METHOD

(30) Priorité: 27.11.2015 FR 1561497
(43) Date de publication de la demande: 03.10.2018
(73) Titulaire: Commissariat à l'Énergie Atomique et aux Énergies Alternatives, 75015 Paris (FR)
(72) Inventeur: ROTHMAN, Johan, 38000 Grenoble (FR)
(74) Mandataire: Brevalex
(86) Numéro de dépôt international: PCT/EP2016/078793
(87) Numéro de publication internationale: WO 2017/089528

(56) Documents cités:
- EP-A1- 0 262 030
- EP-A1- 0 350 351
- FR-A1- 2 983 347
- US-A- 5 177 580
- US-A- 5 602 414

## Description

### DOMAINE TECHNIQUE

Le domaine de l'invention est celui des photo-détecteurs comprenant un réseau de diodes, tel qu'un réseau matriciel, fabriquées sur un substrat semi-conducteur. L'invention a trait plus précisément aux diodes de type p/n ou n/p qui peuvent être utilisées pour des imageurs dans le visible ou dans l'infrarouge.

### ÉTAT DE LA TECHNIQUE ANTÉRIEURE

Dans de nombreuses applications de photo-détection, des diodes sont agencées en matrices de diodes sur un substrat. Dans une matrice, les diodes sont agencées en lignes et en colonnes. Une matrice de diode peut être utilisée pour permettre une détection d'un rayonnement électromagnétique. Il peut en effet se former des paires électrons-trous par interaction entre le rayonnement électromagnétique et le substrat. Cela permet l'apparition d'un courant proportionnel à une intensité du rayonnement incident. Chaque diode forme alors un pixel d'un photo-détecteur.

En venant coupler la matrice de diodes avec un circuit électronique de lecture, il est ainsi possible de capter la variation spatio-temporelle de l'intensité de lumière sur le photo-détecteur. La sensibilité d'un tel photo-détecteur est donnée par sa capacité à traduire des faibles variations spatiales ou temporelles de l'intensité de lumière en un signal comparé utilisable malgré des variations aléatoires (bruit) résultant de phénomènes thermiques et électriques dans les diodes et dans le circuit de lecture.

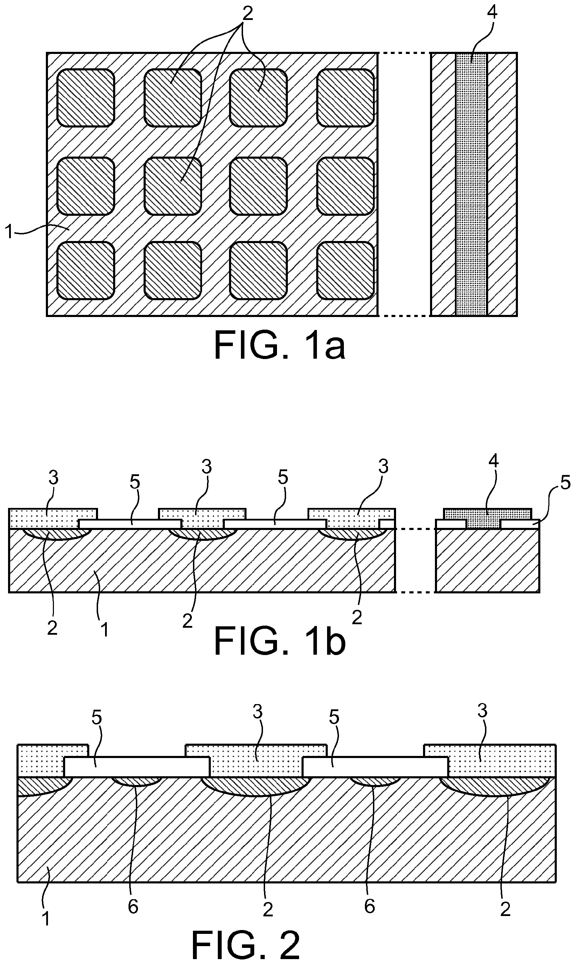

Une telle matrice de diodes est illustrée sur les figures 1a et 1b qui représentent respectivement une vue de dessus et une vue en coupe le long d'une ligne de la matrice. Une diode est formée dans un substrat présentant une couche d'absorption 1 en un matériau semi-conducteur avec une largeur de gap interdit et caractérisé par un type de conductivité. La diode comprend une région de collection 2 de type de conductivité opposé, formant ainsi une jonction p-n.

Comme illustré sur la figure 1b, chaque région de collection est en contact avec un plot métallique 3 formant un contact diode. Une région métallique 4, formée en périphérie de la matrice, est en contact avec le substrat, et forme un contact substrat. Les deux régions de type de conductivité opposé 1, 2 sont protégées d'une dégradation de leurs propriétés chimiques, mécaniques et électroniques au moyen d'une couche de passivation 5 recouvrant la surface du substrat à l'exception des zones de contact diode et de contact substrat.

Dans la région à proximité de l'interface des deux régions de type de conductivité opposé 1, 2 se forme une zone dite de charge espace (ZCE). Cette zone est caractérisée par la présence d'une barrière d'énergie pour les porteurs majoritaires de chaque côté de la jonction. Les photons arrivant dans la couche d'absorption 1 du substrat semi-conducteur peuvent céder leur énergie à un électron. Si l'électron transite entre la bande de valence et la bande de conduction et se déplace jusqu'à la zone de charge d'espace, la charge va être collectée par la région de collection 2. Les charges ainsi collectées peuvent être transférées à un circuit électronique, appelé circuit de lecture, connecté à chaque diode pour disposer d'un signal utilisable. L'extraction de charge est compensée par un appel de charge par le contact substrat qui est, dans le cas généralement utilisé dans l'état de l'art, commun pour l'ensemble des diodes.

Lors de la détection d'un grand flux de photons, chaque diode débite un grand flux de charge, i.e. courant électrique, proportionnel au flux de photon arrivant à proximité de la diode. Les courants de toutes les diodes sont additionnés à travers le substrat jusqu'au contact substrat. En présence d'une résistance électrique dans le substrat, le courant dans celui-ci peut fortement influencer le fonctionnement des diodes.

Cette résistance électrique peut ainsi induire une variation de la polarisation qui altère le fonctionnement des diodes. Dans le cas extrême, elle peut entrainer une annulation du transfert des charges entre les diodes et le circuit de lecture par la suppression de la barrière de potentiel dans les jonctions. Ce phénomène est autant plus important que le nombre de diodes et le flux de photons sur la matrice sont importants.

Cette résistance électrique peut par ailleurs fortement ralentir le transfert des charges dans le circuit de lecture, même en présence d'un flux faible, du fait d'un effet RC collectif.

Par ailleurs, le contrôle de l'état de l'interface entre la couche de passivation 5 et les régions semi-conductrices 1, 2 est crucial pour obtenir une sensibilité maximale. Ceci est dû aux défauts qui peuvent être présents à l'interface, mais aussi à des états dans la passivation qui agissent comme des pièges pour les charges. Les défauts à l'interface peuvent ainsi agir comme des centres de génération/recombinaison des porteurs qui diminuent le signal photonique et augmentent la contribution du courant d'origine thermique ou électrique généré dans le substrat et/ou dans la jonction. Les états pièges dans la passivation sont quant à eux susceptibles de faire varier temporellement la densité de charge locale à proximité de chaque piège. Ces fluctuations peuvent à leur tour générer des fluctuations sur le courant photonique et sur les différents courants d'obscurité.

On cherche donc d'une manière générale à réduire l'effet de résistance série collectif et à stabiliser la performance des diodes afin d'augmenter la sensibilité du photo-détecteur.

On connaît ainsi de la demande de brevet EP 2 806 457 A2 une solution consistant à réaliser un réseau de sur-dopage entre les diodes afin de stabiliser l'interface entre le substrat et la couche de passivation. Cette solution est représentée sur la figure 2. Elle consiste à former des lignes conductrices enterrées 6 qui s'étendent entre les colonnes et entre les lignes de diodes dans la matrice. Ces lignes enterrées 6 sont plus précisément des lignes dopées par implantation ionique avec le même type de dopage que la couche d'absorption 1, et une densité de dopage plus importante.

On connait de la demande de brevet EP 0 350 351 A1 un réseau de diodes à structure mésa séparées par des tranchées usinées dans un substrat. Une couche métallique est déposée dans le fond de chaque tranchée, et un traitement thermique est effectué qui entraîne une diffusion de métal dans la couche d'absorption depuis la couche métallique et forme une région surdopée sous chaque tranchée. L'usinage des tranchées crée toutefois des défauts, et le traitement thermique doit permettre de les supprimer tout en permettant de fixer le niveau de dopage p et de réaliser la diffusion de métal. Les défauts persistent néanmoins, et il n'est pas possible de réaliser un contact ohmique de qualité de qualité dans le fond des tranchées.

Le document US5602414 divulgue la disposition d'un maillage métallique entre les photodiodes de photodétecteurs à réseaux de diodes.

### EXPOSÉ DE L'INVENTION

L'invention a pour objectif d'améliorer la sensibilité des photo-détecteurs à réseau de diodes. Pour ce faire, elle propose un dispositif de photo-détection comportant un substrat et un réseau de diodes tel que défini par la revendication 1.

Certains aspects préférés mais non limitatifs de ce dispositif sont les suivants :
- il comprend un contact substrat périphérique agencé sur au moins un côté du réseau de diodes ;
- le maillage métallique est en contact électrique avec le contact substrat périphérique ;
- le maillage de conduction présente une pluralité de canaux de conduction agencés de manière à ce qu'on retrouve un canal de conduction intercalé entre les régions de collection de chacune des diodes adjacentes du réseau de diodes ;
- la couche d'absorption est une couche de CdHgTe ;
- la couche d'absorption présente un dopage intrinsèque par des lacunes de mercure ou un dopage extrinsèque par incorporation d'arsenic ;
- la couche d'absorption présente une augmentation de gap graduelle depuis face arrière du substrat dans l'épaisseur de la couche d'absorption ;
- la couche d'absorption présente une diminution de gap soudaine qui intervient à une profondeur donnée dans l'épaisseur de la couche d'absorption depuis la face arrière du substrat, et qui délimite une région de plus fort gap à proximité de la face arrière dans laquelle on retrouve le maillage de conduction, et une région de plus faible gap à distance de la face arrière du substrat.

L'invention porte également sur un procédé de fabrication d'un tel dispositif de photodétection, défini par la revendication 10. Ce procédé comprend notamment la formation d'un maillage métallique sur la face arrière du substrat, la formation du maillage de conduction étant réalisée par diffusion de métal depuis le maillage métallique.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels, outre les figures la, 1b et 2 déjà commentées :
- les figures 3a et 3b sont respectivement une vue de dessus et une vue en coupe le long d'une ligne de diodes d'une matrice de diodes conforme à l'invention ;
- les figures 4a et 4b illustrent des variantes de réalisation de l'invention avec variation de gap dans l'épaisseur de la couche d'absorption ;
- les figures 5a-5f illustrent une réalisation possible d'un procédé de fabrication d'un dispositif de photo-détection conforme à l'invention.

### EXPOSÉ DÉTAILLÉ DE MODES DE RÉALISATION PARTICULIERS

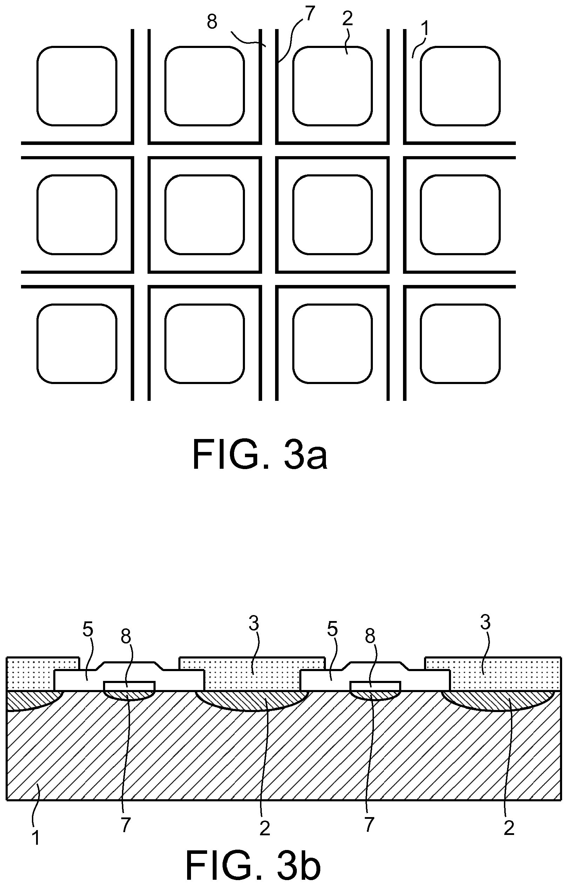

En référence aux figures 3a et 3b, l'invention porte sur un dispositif de photodétection comportant un substrat et un réseau de diodes. Le substrat comprend une face avant destinée à recevoir un rayonnement électromagnétique et une face arrière opposée à la face avant et sensiblement parallèle à celle-ci. Le substrat comprend également une couche d'absorption 1 présentant un premier type de dopage, chaque diode comporte dans la couche d'absorption 1 une région de collection 2 qui affleure la face arrière du substrat et présente un deuxième type de dopage opposé au premier type.

La couche d'absorption 1 est par exemple une couche de CdHgTe. Une telle couche peut notamment être formée par épitaxie sur un substrat de CdZnTe. Sa composition en cadmium peut être comprise entre 20 et 40%. Son épaisseur est par exemple de 8 µm.

Le dopage de la couche d'absorption 1 peut être de type p. Il peut s'agir d'un dopage intrinsèque par des lacunes de mercure ou d'un dopage extrinsèque, par exemple par incorporation d'arsenic. La densité de dopage de la couche d'absorption est typiquement comprise entre 10¹⁵ et 10¹⁷ at/cm³.

Le dopage de la région de collection 2 est alors de type n. Ce dopage peut être obtenu par implantation ionique, par exemple une implantation de bore.

Bien entendu, l'invention s'étend au cas d'un dopage de la couche d'absorption 1 de type n, par exemple par incorporation d'indium, et d'un dopage de la région de collection 2 de type p, obtenu par exemple par implantation d'arsenic.

Le dispositif selon l'invention comprend en outre, sous la surface du substrat au niveau de laquelle sont réalisées les régions de collection (par surface du substrat, on désigne la face arrière du substrat opposée à la face avant recevant le rayonnement électromagnétique), un maillage de conduction comprenant au moins un canal de conduction 7 intercalé entre les régions de collection de deux diodes adjacentes. L'au moins un canal de conduction 7 présente le premier type de dopage et une plus grande densité de dopage que la couche d'absorption. La densité de dopage de l'au moins un canal de conduction est typiquement comprise entre 10¹⁶ et 10¹⁸ at/cm³.

Le maillage de collection est enterré dans le substrat et affleure la face arrière du substrat. Différentes topologies de maillage de conduction peuvent être mises en œuvre dans le cadre de l'invention. De préférence, ce maillage de conduction présente au moins un canal de conduction qui s'étend entre deux rangées adjacentes de diodes. En d'autres termes, ce canal s'étend entre deux lignes adjacentes ou deux colonnes adjacentes de diodes.

Le maillage de conduction présente de préférence une pluralité de canaux de conduction qui s'étendent chacun entre deux rangées (lignes ou colonnes) adjacentes de diodes. En particulier, on peut prévoir une pluralité de canaux de conduction agencés de manière à ce qu'on retrouve un canal de conduction intercalé entre les régions de collection de chacune des diodes adjacentes du réseau de diodes. En d'autres termes, et comme représenté sur la figure 3a dans le cas d'un réseau matriciel de diodes, chaque diode est séparée de ses diodes adjacentes par quatre canaux de conduction qui viennent s'entrecroiser.

Dans le cadre de l'invention, la densité de dopage de l'au moins un canal de conduction 7 est issue d'une diffusion de métal dans la couche d'absorption. Le métal est par exemple de l'or ou du cuivre lorsqu'il s'agit de réaliser un dopage de type p du maillage de conduction 7. Le métal est par exemple de l'indium lorsqu'il s'agit de réaliser un dopage de type n du maillage de conduction 7.

Le métal diffusé vient se placer sur un site de substitution dans le réseau cristallin du semi-conducteur en créant des états donneurs ou accepteurs conduisant au sur-dopage. La diffusion de métal est de préférence réalisée par un traitement thermique.

En plus de stabiliser l'interface entre le semi-conducteur et la couche de passivation de la même façon que dans la demande de brevet EP 2 806 457 A2, la formation du maillage de conduction fortement dopé par diffusion de métal permet de réduire la formation de défauts par rapport à une réalisation de la région fortement dopée par implantation ionique telle que proposée dans la demande EP 2 806 457 A2. Cette réduction de la formation de défauts conduit à une amélioration de la performance des diodes avec une réduction du courant d'obscurité et du nombre de diodes en défaut de bruit.

La diffusion de métal s'effectue depuis un maillage métallique 8 présent directement sur la surface du substrat, par exemple un maillage d'or, de cuivre ou d'indium. Ce maillage métallique 8 recouvre donc directement et intégralement le maillage de conduction 7. Il est ainsi distribué sur la surface du substrat selon le même motif que le maillage de conduction sur-dopé.

Le maillage métallique 8 forme un contact ohmique avec le substrat dans lequel le courant est directement conduit. Ainsi la présence de ce maillage métallique apporte avantageusement une forte réduction de la résistance d'accès série, et donc des effets de dépolarisation et de RC collectifs.

Le dispositif selon l'invention comporte par ailleurs un contact substrat périphérique agencé sur au moins un côté du réseau de diodes. Ce contact n'est pas représenté sur les figures 3a et 3b mais est similaire à celui discuté précédemment en liaison avec les figures la et 1b. Un tel contact substrat périphérique permet de réaliser une connexion électrique entre le substrat et le circuit de lecture sur la périphérie du réseau de diodes libérant ainsi de la place entre les diodes, et permettant avantageusement de réaliser un réseau de diodes avec un faible pas entre les diodes.

Le maillage de conduction 7 est de préférence en contact électrique avec le contact substrat périphérique, notamment par l'intermédiaire du maillage métallique 8.

Le dispositif selon l'invention comporte par ailleurs une couche de passivation 5 qui recouvre le substrat à l'exception de régions de contact d'un plot électriquement conducteur 3 avec une région de collection 2 d'une diode, et le cas échéant d'une région de contact périphérique d'un plot électriquement conducteur avec le substrat.

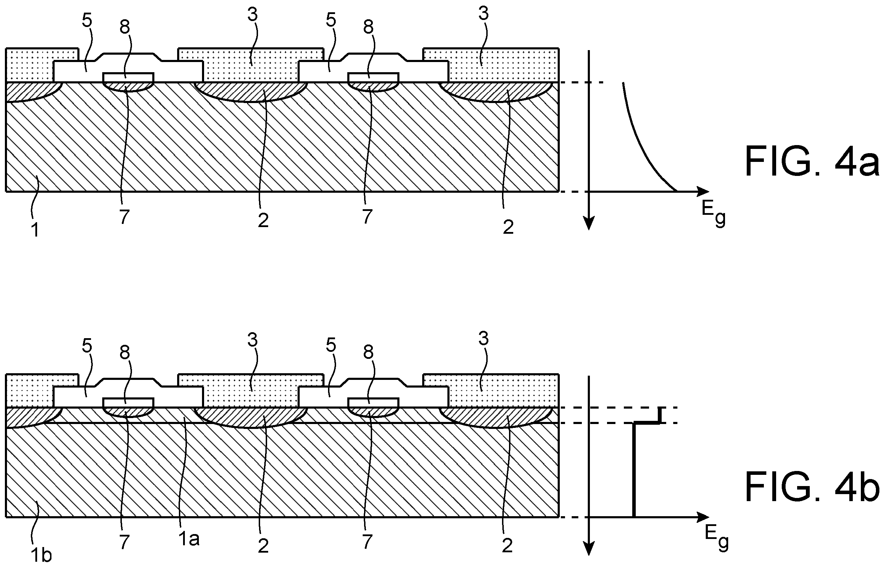

Dans des variantes de réalisation représentées sur les figures 4a et 4b, la couche d'absorption présente une variation de gap Eg (énergie de bande interdite) depuis la surface du substrat dans l'épaisseur de la couche d'absorption. Avec une couche d'absorption en CdHgTe par exemple, cette variation de gap peut être obtenue en faisant varier la teneur en cadmium.

Sur la figure 4a, la couche d'absorption 1 présente une augmentation de gap graduelle depuis la surface du substrat dans l'épaisseur de la couche d'absorption. Cette variante permet de limiter la diffusion des porteurs minoritaires entre les diodes du fait d'une augmentation de la probabilité de collectionner les charges dans le pixel où ils ont été photo-générés. Elle permet ainsi de diminuer l'étalement de la réponse sur les pixels voisins. Cette variante est avantageusement utilisée dans le cas d'un réseau de détection à faible pas.

Sur la figure 4b, la couche d'absorption présente une diminution de gap soudaine qui intervient à une profondeur donnée dans l'épaisseur de la couche d'absorption depuis la surface du substrat. La couche d'absorption est alors constituée de deux régions la, 1b avec une valeur de gap d'énergie différente, à savoir une région la de grand gap immédiatement sous la surface de la passivation et une région 1b de faible gap. L'étendue de la région la de grand gap est telle qu'on retrouve dans cette région la le maillage de conduction 7. Les régions de collection 2 dépassent quant à elles de préférence de la région la, ou s'étendent à tout le moins dans la région la jusqu'à être adjacentes avec l'interface de changement de gap entre les régions la et 1b. La présence de la région la de grand gap permet de limiter les effets éventuellement néfastes liés aux défauts induits par la formation de cette région immédiatement sous la surface du substrat.

L'invention n'est pas limitée au dispositif de photo-détection précédemment décrit, mais s'étend également à un procédé de fabrication d'un dispositif de photodétection comportant un substrat et un réseau de diodes, tel que défini par la revendication 10.

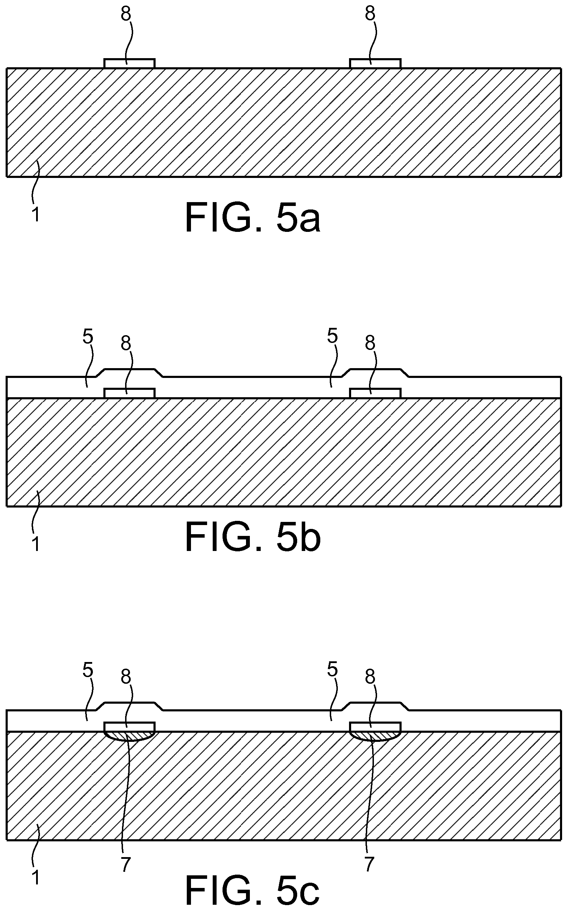

Les figures 5a-5f illustrent un exemple de réalisation d'un tel procédé qui débute par une étape de fourniture d'un substrat portant la couche d'absorption 1, par exemple en CdHgTe. Suite à une préparation de surface du substrat, on procède comme représenté sur la figure 5a au dépôt du maillage métallique 8 sur la surface du substrat. Le maillage métallique comprend par exemple plusieurs lignes présentant une largeur de 1 µm et une épaisseur de 500 nm. La figure 5b illustre le dépôt d'une couche de passivation 5 sur le substrat et le maillage métallique. On procède ensuite à un recuit de stabilisation de l'interface entre le substrat et la couche de passivation. Ce recuit permet la diffusion de métal du maillage métallique en direction du substrat, résultant comme représenté sur la figure 5c, en la formation du maillage de conduction 7 dans le substrat directement en dessous du maillage métallique 8 en surface du substrat. Lorsque la couche de passivation est déposée avant la diffusion du métal, elle fait barrière à l'évaporation de Hg depuis la couche d'absorption et un simple recuit sous vide peut être utilisé. La couche de passivation peut être cependant déposée après, un recuit sous pression de vapeur saturante de Hg pouvant alors être mis en œuvre.

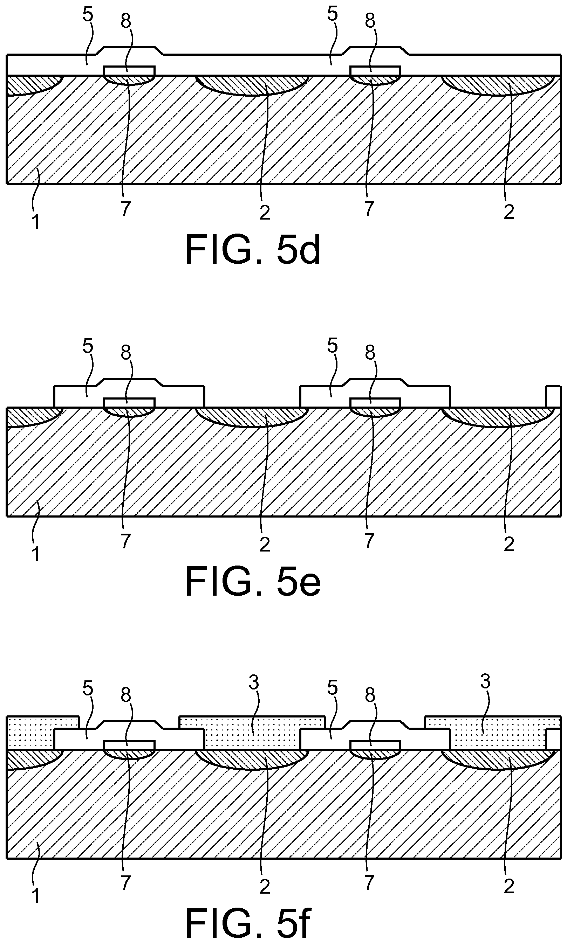

En référence à la figure 5d, on procède ensuite à la formation des régions de collection 2 au moyen d'une implantation ionique au travers un masque approprié. Le diamètre de chaque région de collection est par exemple compris entre 5 et 20 µm, et ces régions sont espacées d'un pas de pixel par exemple compris entre 5 et 30 µm.

On procède ensuite comme représenté à la figure 5e à l'ouverture de la couche de passivation 5 au niveau de chaque pixel, ainsi qu'en périphérie du réseau pour la formation ultérieure du contact substrat.

On procède ensuite comme représenté en figure 5f au dépôt d'une couche de métal et sa gravure au niveau de chaque pixel et à la périphérie pour former les contacts diode 3 et le contact substrat. L'épaisseur de ces contacts est typiquement inférieure à 1 µm.

L'invention trouve avantageusement application pour l'imagerie infrarouge, et en particulier pour l'imagerie grand format où elle permet de réduire l'effet de dépolarisation en cas de fort flux, pour l'imagerie active où elle permet de réduire l'effet de la dépolarisation et le ralentissement causé par l'effet RC collectif, ainsi que pour l'imagerie à très faible pas où elle permet de stabiliser l'interface entre les diodes et d'augmenter la fonction de transfert de modulation du photo-détecteur.

## Revendications

1. Dispositif de photo-détection comportant un substrat dans lequel est formé un réseau de diodes, le substrat comprenant une face avant destinée à recevoir un rayonnement électromagnétique, une face arrière opposée et sensiblement parallèle à la face avant et une couche d'absorption (1) présentant un premier type de dopage, chaque diode comportant dans la couche d'absorption une région de collection (2) affleurant la face arrière du substrat et présentant un deuxième type de dopage opposé au premier type, le dispositif comportant, enterré dans le substrat et affleurant la face arrière du substrat, un maillage de conduction (7) comprenant au moins un canal de conduction intercalé entre les régions de collection (2) de deux diodes adjacentes, l'au moins un canal de conduction (7) présentant le premier type de dopage et une plus grande densité de dopage que la couche d'absorption,
**caractérisé en ce que** le maillage de conduction (7) est recouvert d'un maillage métallique (8) présent sur la face arrière du substrat, **en ce que** la densité de dopage de l'au moins un canal de conduction (7) est issue d'une diffusion de métal dans la couche d'absorption depuis le maillage métallique (8), et
**en ce qu'**il comporte en outre une couche de passivation (5) qui recouvre le substrat et le maillage métallique à l'exception de régions de contact d'un plot électriquement conducteur (3) avec une région de collection (2) d'une diode.

2. Dispositif selon la revendication 1, comprenant un contact substrat (4) périphérique agencé sur au moins un côté du réseau de diodes.

3. Dispositif selon la revendication 2, dans lequel le maillage métallique (8) est en contact électrique avec le contact substrat périphérique.

4. Dispositif selon l'une des revendications 1 à 3, dans lequel le maillage de conduction (7) présente au moins un canal de conduction s'étendant entre deux rangées adjacentes de diodes.

5. Dispositif selon la revendication 4, dans lequel le maillage de conduction (7) présente une pluralité de canaux de conduction agencés de manière à ce qu'on retrouve un canal de conduction intercalé entre les régions de collection de chacune des diodes adjacentes du réseau de diodes.

6. Dispositif selon l'une des revendications 1 à 5, dans lequel la couche d'absorption (1) est une couche de CdHgTe.

7. Dispositif selon la revendication 6, dans lequel la couche d'absorption (1) présente un dopage intrinsèque par des lacunes de mercure ou un dopage extrinsèque par incorporation d'arsenic.

8. Dispositif selon l'une des revendications 1 à 7, dans lequel la couche d'absorption (1) présente une augmentation de gap graduelle depuis la face arrière du substrat dans l'épaisseur de la couche d'absorption.

9. Dispositif selon l'une des revendications 1 à 7, dans lequel la couche d'absorption (1) présente une diminution de gap soudaine qui intervient à une profondeur donnée dans l'épaisseur de la couche d'absorption depuis la face arrière du substrat, et qui délimite une région (1a) de plus fort gap à proximité de la face arrière du substrat dans laquelle on retrouve le maillage de conduction (7), et une région (1b) de plus faible gap à distance de la face arrière du substrat.

10. Procédé de fabrication d'un dispositif de photodétection comportant un substrat dans lequel est formé un réseau de diodes, le substrat comprenant une face avant destinée à recevoir un rayonnement électromagnétique, une face arrière opposée et sensiblement parallèle à la face avant et une couche d'absorption (1) présentant un premier type de dopage, chaque diode comportant dans la couche d'absorption (1) une région de collection (2) affleurant la face arrière du substrat et présentant un deuxième type de dopage opposé au premier type,
le procédé comprenant une étape de formation, enterré dans le substrat et affleurant la face arrière du substrat, d'un maillage de conduction (7) comprenant au moins un canal de conduction intercalé entre les régions de collection de deux diodes adjacentes, l'au moins un canal de conduction présentant le premier type de dopage et une plus grande densité de dopage que dans la couche d'absorption,
le procédé étant **caractérisé en ce qu'**il comprend la formation d'un maillage métallique (8) sur la face arrière du substrat, **en ce que** ladite étape de formation du maillage de conduction (7) est réalisée par diffusion de métal depuis le maillage métallique (8) et **en ce qu'**il comprend le dépôt d'une couche de passivation (5) sur le substrat et le maillage métallique à l'exception de régions de contact d'un plot électriquement conducteur (3) avec une région de collection (2) d'une diode.

11. Procédé selon la revendication 10, dans lequel le dépôt de la couche de passivation (5) est réalisé après la formation du maillage métallique (8), ledit dépôt étant suivi d'un recuit de stabilisation de l'interface entre le substrat et la couche de passivation au cours duquel s'opère la diffusion de métal depuis le maillage métallique résultant en la formation du maillage de conduction.

## Patentansprüche

1. Vorrichtung zur Fotodetektion, umfassend ein Substrat, in dem ein Gitter von Dioden gebildet ist, wobei das Substrat eine Vorderfläche umfasst, die dazu ausgelegt ist, eine elektromagnetische Strahlung zu empfangen, eine entgegengesetzte Rückfläche, die im Wesentlichen parallel zur Vorderfläche ist, und eine Absorptionsschicht (1), die einen ersten Dotierungstyp aufweist, wobei jede Diode in der Absorptionsschicht eine Sammelregion (2) umfasst, die mit der Rückfläche des Substrats bündig ist und einen zweiten Dotierungstyp aufweist, der zum ersten Typ entgegengesetzt ist, wobei die Vorrichtung, vergraben in dem Substrat und bündig mit der Rückfläche des Substrats, ein Leitungsnetz (7) umfasst, das wenigstens einen Leitungskanal umfasst, der zwischen den Sammelregionen (2) von zwei benachbarten Dioden eingefügt ist, wobei der wenigstens eine Leitungskanal (7) den ersten Dotierungstyp und eine größere Dotierungsdichte aufweist als die Absorptionsschicht,
**dadurch gekennzeichnet, dass** das Leitungsnetz (7) mit einem metallischen Netz (8) bedeckt ist, das auf der Rückfläche des Substrats vorhanden ist, dass die Dotierungsdichte des wenigstens einen Leitungskanals (7) aus einer Diffusion von Metall in die Absorptionsschicht von dem metallischen Netz (8) ausgehend stammt, und dass es ferner eine Passivierungsschicht (5) umfasst, die das Substrat und das metallische Netz bedeckt, mit Ausnahme von Regionen des Kontakts eines elektrisch leitenden Punkts (3) mit einer Sammelregion (2) einer Diode.

2. Vorrichtung nach Anspruch 1, umfassend einen Umfangssubstratkontakt (4), der auf wenigstens einer Seite des Gitters von Dioden angeordnet ist.

3. Vorrichtung nach Anspruch 2, bei der das metallische Netz (8) in elektrischem Kontakt mit dem Umfangssubstratkontakt ist.

4. Vorrichtung nach einem der Ansprüche 1 bis 3, bei der das Leitungsnetz (7) wenigstens einen Leitungskanal aufweist, der sich zwischen zwei benachbarten Reihen von Dioden erstreckt.

5. Vorrichtung nach Anspruch 4, bei der das Leitungsnetz (7) eine Mehrzahl von Leitungskanälen aufweist, die derart angeordnet sind, dass man einen Leitungskanal eingefügt zwischen den Sammelregionen von jeder der benachbarten Dioden des Gitters von Dioden findet.

6. Vorrichtung nach einem der Ansprüche 1 bis 5, bei der die Absorptionsschicht (1) eine Schicht aus CdHgTe ist.

7. Vorrichtung nach Anspruch 6, bei der die Absorptionsschicht (1) eine intrinsische Dotierung mittels Lücken aus Quecksilber aufweist, oder eine extrinsische Dotierung mittels Beimischung von Arsen.

8. Vorrichtung nach einem der Ansprüche 1 bis 7, bei der die Absorptionsschicht (1) eine schrittweise Vergrößerung des Gaps ausgehend von der Rückfläche des Substrats in die Dicke der Absorptionsschicht aufweist.

9. Vorrichtung nach einem der Ansprüche 1 bis 7, bei der die Absorptionsschicht (1) eine schlagartige Verringerungs des Gaps aufweist, die in einer gegebenen Tiefe in der Dicke der Absorptionsschicht ausgehend von der Rückfläche des Substrats auftritt, und die eine Region (1a) mit stärkerem Gap in der Nähe der Rückfläche des Substrats begrenzt, in der man das Leitungsnetz (7) findet, sowie eine Region (1b) mit schwächerem Gap im Abstand von der Rückfläche des Substrats.

10. Verfahren zur Herstellung einer Vorrichtung zur Fotodetektion, umfassend ein Substrat, in dem ein Gitter von Dioden gebildet ist, wobei das Substrat eine Vorderfläche umfasst, die dazu ausgelegt ist, eine elektromagnetische Strahlung zu empfangen, eine entgegengesetzte Rückfläche, die im Wesentlichen parallel zur Vorderfläche ist, und eine Absorptionsschicht (1), die einen ersten Dotierungstyp aufweist, wobei jede Diode in der Absorptionsschicht (1) eine Sammelregion (2) umfasst, die mit der Rückfläche des Substrats bündig ist und einen zweiten Dotierungstyp aufweist, der zum ersten Typ entgegengesetzt ist,
wobei das Verfahren einen Schritt umfasst des Bildens, eingegraben in dem Substrat und bündig mit der Rückfläche des Substrats, eines Leitungsnetzes (7), umfassend wenigstens einen Leitungskanal, der zwischen den Sammelregionen von zwei benachbarten Dioden eingefügt ist, wobei der wenigstens eine Leitungskanal den ersten Dotierungstyp und eine größere Dotierungsdichte aufweist als die Absorptionsschicht,
wobei das Verfahren **dadurch gekennzeichnet ist, dass** es die Bildung eines metallischen Netzes (8) auf der Rückfläche des Substrats umfasst, dass der Schritt des Bildens des Leitungsnetzes (7) mittels Diffusion von Metall ausgehend von dem metallischen Netz (8) realisiert wird, und dass es die Aufbringung einer Passivierungsschicht (5) auf dem Substrat und dem metallischen Netz umfasst, mit Ausnahme von Kontaktregionen eines elektrisch leitenden Punkts (3) mit einer Sammelregion (2) einer Diode.

11. Verfahren nach Anspruch 10, bei dem die Aufbringung der Passivierungsschicht (5) nach dem Bilden des metallischen Netzes (8) realisiert wird, wobei auf das Aufbringen ein Glühen zur Stabilisierung der Grenzfläche zwischen dem Substrat und der Passivierungsschicht folgt, in dessen Verlauf die Diffusion von Metall ausgehend von dem metallischen Netz erfolgt, die in der Bildung des Leitungsnetzes resultiert.

## Claims

1. A photodetection device including a substrate inn which is formed an array of diodes, the substrate comprising a front face for receiving an electromagnetic radiation, a rear face opposite and substantially parallel to the front face and an absorption layer (1) having a first doping type, each diode including in the absorption layer a collection layer (2) being flush with the rear face of the substrate and having a second doping type opposite to the first type, the device including, buried in the substrate and being flush with the rear face of the substrate, a conduction meshing (7) comprising at least one conduction channel sandwiched between the collection regions (2) of two adjacent diodes, the at least one conduction channel (7) having the first doping type and a higher doping density than the absorption layer, **characterised in that** the conduction meshing (7) is covered with a metallic meshing (8) present on the rear face of the substrate, **in that** the doping density of the at least one conduction channel (7) results from a metal diffusion in the absorption layer from the metallic meshing (8), and **in that** it further comprises a passivation layer (5) that covers the substrate and the metallic meshing except for contact regions of an electrically conductive bump contact (3) with a collection region (2) of a diode.

2. The device according to claim 1, comprising a peripheral substrate contact (4) arranged on at least one side of the array of diodes.

3. The device according to claim 2, wherein the metallic meshing (8) is in electric contact with the peripheral substrate contact.

4. The device according to one of claims 1 to 3, wherein the conduction meshing (7) has at least one conduction channel extending between two adjacent lines of diodes.

5. The device according to claim 4, wherein the conduction meshing (7) has a plurality of conduction channels arranged such that there is a conduction channel sandwiched between the collection regions of each of the adjacent diodes of the array of diodes.

6. The device according to one of claims 1 to 5, wherein the absorption layer (1) is a layer of CdHgTe.

7. The device according to claim 6, wherein the absorption layer (1) has an intrinsic doping by mercury vacancies or an extrinsic doping by arsenic incorporation.

8. The device according to one of claims 1 to 7, wherein the absorption layer (1) has a gradual bandgap increase from the rear face of the substrate in the thickness of the absorption layer.

9. The device according to one of claims 1 to 7, wherein the absorption layer (1) has an abrupt bandgap decrease which appears at a given depth in the thickness of the absorption layer from the rear face of the substrate, and which delimits a region (1a) having a higher bandgap in the proximity of the rear face of the substrate in which there is the conduction meshing (7), and a region (1b) having a lower bandgap away from the rear face of the substrate.

10. A method for manufacturing a photodetection device including a substrate in which is formed an array of diodes, the substrate comprising a front face for receiving an electromagnetic radiation, a rear face opposite to and substantially parallel to the front face and an absorption layer (1) having a first doping type, each diode including in the absorption layer (1) a collection region (2) being flush with the rear face of the substrate and having a second doping type opposite to the first type,
the method including a step of forming, buried in the substrate and being flush with the rear face of the substrate, a conduction meshing (7) comprising at least one conduction channel sandwiched between the collection regions of two adjacent diodes, the at least one conduction channel having the first doping type and a higher doping density than in the absorption layer,
the method being **characterized in that** it comprises forming a metallic meshing (8) on the rear face of the substrate, **in that** said step of forming the conduction meshing (7) is made by metal diffusion from the metallic meshing (8) and **in that** it comprises depositing a passivation layer (5) onto the substrate and the metallic meshing except for contact regions of an electrically conductive bump contact (3) with a collection region (2) of a diode.

11. The method according to claim 10, wherein depositing the passivation layer (5) is made after the formation of the metallic meshing (8), said depositing being followed by an annealing for stabilizing the interface between the substrate and the passivation layer during which is realized the metal diffusion from the metallic meshing (8) that results in the formation of conduction meshing.
